# EUROPÄISCHE PATENTANMELDUNG

(11) **EP 1 008 636 A2**
(43) Veröffentlichungstag der Anmeldung: **14.06.2000**
(21) Anmeldenummer: 99113962.7
(22) Anmeldetag: 17.07.1999
(51) Int. Cl.: C09J 5/06

(54) **Klebeverfahren**

(30) Priorität: 07.12.1998 DE 19856333
(71) Anmelder: ROBERT BOSCH GMBH, 70442 Stuttgart (DE)
(72) Erfinder: Hauer, Heiner, 70734 Fellbach (DE); Kuke, Albrecht, 71549 Auenwald (DE); Mauritz, Matthias, 71522 Backnang (DE)

(57) **Zusammenfassung**

Klebeverfahren zum Verbinden zweier Teile (1, 2) über eine diese miteinander verbindende, länger aushärtende Klebemittelschicht (4), nachdem zuvor eine Justage vorgenommen worden ist.
Nach dem Aufbringen der Klebemittelschicht (4) und nach dem Anbringen einer Justagevorrichtung (3) wird ein die beiden Teile (1, 2) miteinander verbindendes, kürzer aushärtendes UV-Klebemittel (5) am Rand der Klebemittelschicht (4) derart aufgebracht, dass es für eine UV-Bestrahlung zugänglich ist. Anschließend wird das UV-Klebemittel (5) ausgehärtet, die Justagevorrichtung (3) entfernt und schließlich die länger aushärtende Klebemittelschicht (4) ausgehärtet.

## Beschreibung

### Stand der Technik

Die Erfindung geht von der Gattung aus, wie im unabhängigen Anspruch 1 angegeben.

In vielen Bereichen der Technik, wie z. B. in der Elektronik, Optoelektronik oder Mikrooptik, werden Klebeverbindungen verwendet, um verschiedene Teile miteinander zu verbinden. Dabei ist es häufig erforderlich, daß die zu verbindenden Teile mit hoher Präzision zueinander ausgerichtet sein müssen, um beispielsweise bei optischen Anwendungen eine hohe Lichtüberkopplung zwischen den zu verbindenden Teilen zu erhalten oder bei elektronischen Anwendungen mit sehr kleinen elektrischen Kontakten eine sichere Kontaktierung zu gewährleisten. Nach dem Stand der Technik sind für solche Klebeverbindungen eine Vielzahl von Klebemitteln in Gebrauch. Eine besonders hohe Festigkeit wird mit Klebemitteln auf Epoxy-Basis erzielt. Diese Klebemittel können durch Beimengungen eines metallischen Füllstoffes auch elektrisch leitend hergestellt werden, um so dauerhafte elektrische Kontaktierungen zu ermöglichen. Durch keramische Beimengungen kann eine gute Wärmeleitfähigkeit erzielt werden. Für eine gute Haftung dieser Epoxy-Klebemittel ist es erforderlich, daß sie über eine länger Zeit bei erhöhter Temperatur ausgehärtet werden. Zur Erzielung einer guten Klebekraft ist typischerweise eine Aushärtetemperatur von bis zu 120°C über eine Zeitdauer von bis zu 24 Stunden erforderlich. Bei einer hohen Aushärtetemperatur von 120°C ist eine kürzere Zeit von ca. 1 Stunde und bei einer geringeren Aushärtetemperatur von 80°C eine längere Aushärtezeit von 24 Stunden erforderlich, wobei die höhere Aushärtetemperatur die bessere Haftung ergibt. Bei Anwendungen mit großen Anforderungen an die Positionstoleranzen, wie sie beispielsweise in den oben genannten Technikbereichen üblich sind, darf sich während der Aushärtezeit die relative Position der zu verbindenden Teile nicht verändern, um Dejustierungen zu vermeiden. Die Aushärtung muß deshalb in der Justagevorrichtung geschehen, die zur Positionsausrichtung verwendet wurde. Diese Vorrichtung wird dann für den Produktionsprozeß während der Aushärtezeit blockiert. Zur Erzielung eines hohen Produktionsdurchsatzes müssen entweder viele Justage- und Klebevorrichtungen gleichzeitig verwendet werden, was mit hohen Kosten verbunden ist, oder/und die Aushärtezeit muß durch Verwendung einer hohen Aushärtetemperatur verkürzt werden. Die Aushärtetemperatur wird aber durch den Temperatureinsatzbereich der zu verklebenden Teile in vielen Fällen eingeschränkt.

Um die oben genannten Nachteile für den Produktionsprozeß größerer Stückzahlen zu vermeiden, werden nach dem Stand der Technik Klebemittel verwendet, die transparent sind und durch Bestrahlung mit ultraviolettem Licht aushärten. Diese sogenannten UV-Kleber werden einige Sekunden bis zu maximal 10 Minuten mit UV-Licht bei Raumtemperatur bestahlt. Gegenüber den Epoxy-Klebemitteln wird dadurch eine wesentlich kürzere Prozeßdurchlaufzeit erreicht. Zur vollständigen Durchhärtung der Klebeverbindung ist es jedoch erforderlich, daß das gesamte Volumen des UV-Klebemittels vom UV-Licht bestrahlt werden kann. Hierzu muß bei einer flächenhaften Klebung von zwei zu verbindenden Teilen mindestens ein Teil für UV-Licht transparent sein. Andernfalls ist nur eine Klebenaht oder eine Klebung im frei zugänglichen Randbereich der zu verbindenden Teile möglich. Dadurch wird der Anwendungsbereich von UV-Klebemitteln stark eingeschränkt. Weitere Nachteile von UV-Klebemitteln gegenüber Epoxy-Klebemitteln sind die wesentlich geringere Haftfestigkeit der UV-Klebemittel und die niedrigere Glasübergangstemperatur, welche den Temperatureinsatzbereich einschränkt.

### Vorteile der Erfindung

Der Anmeldungsgegenstand mit den Merkmalen des Anspruches 1 hat folgenden Vorteil:
Er verbindet Vorteile der oben beschriebenen Klebetechniken und vermeidet Nachteile von ihnen. Eine zur Justage erforderliche Justagevorrichtung ist nach kurzer Zeit wieder verfügbar, und es wird letztlich eine hohe Haftfestigkeit erreicht.
Vorteilhafte Weiterbildungen sind in den abhängigen Ansprüchen angegeben, deren Merkmale auch, soweit sinnvoll, miteinander kombiniert werden können.

### Zeichnung

Ein Ausführungsbeispiel der Erfindung ist in der Zeichnung dargestellt und im Folgenden näher erläutert. Schematisch sind gezeigt in
- Figur 1:: zwei miteinander zu verbindende Teile, die mit hoher Genauigkeit zueinander justiert und verklebt werden sollen,
- Figur 2:: ein Ofen für die Nachbehandlung der Teile.

Im Wesentlichen gleiche Teile in unterschiedlichen Figuren sind mit gleichen Bezugszeichen versehen.

### Beschreibung des Ausführungsbeispiels

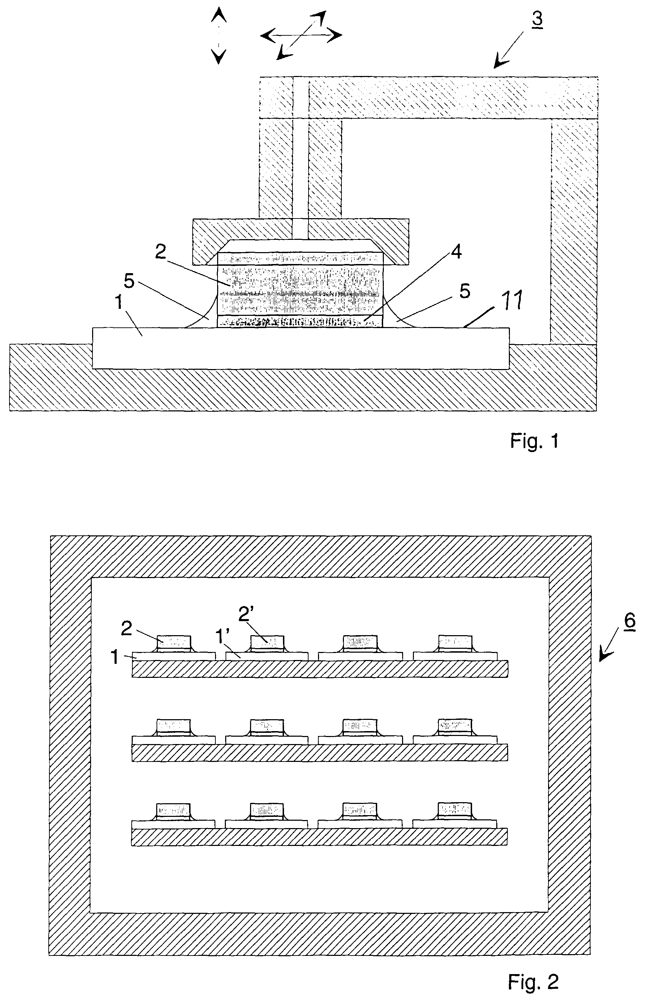

Fig. 1 zeigt zwei miteinander zu verbindende Teile, die mit hoher Genauigkeit zueinander justiert werden sollen. Beispielhaft und ohne Beschränkung der Allgemeinheit ist als erstes Teil ein Substrat 1 und als zweites Teil ein Bauteil 2 dargestellt. Diese beiden Teile können in einer Justagevorrichtung 3 mit hoher Genauigkeit zueinander positioniert werden. Zwischen der Oberseite 11 des Substrates 1 und der Unterseite des Bauteils 2 ist im Bereich der gegenseitigen Überdeckung eine Schicht eines Epoxy-Klebemittels 4 angebracht. Vor oder nach der Justage der zu verklebenden Teile 1 und 2 mittels der Justagevorrichtung 3 wird im Randbereich eines der Teile 1 oder 2 ein UV-Klebemittels 5 so angebracht, daß es den Randbereich des Teils 2 (der sich an den Bereich der gegenseitigen überdeckung anschließt) und einen Teil der Oberseite 11 des anderen Teils 1 benetzt und überall von mindestens einer Seite aus mit UV-Licht beleuchtet werden kann. Nach der Justage wird das UV-Klebemittel mit UV-Licht beleuchtet und dadurch eine vorläufige Fixierung der beiden zu verbindenden Teile erreicht. Diese vorläufige Fixierung ist so stabil, daß die provisorisch verbundenen Teile 1 und 2 aus der Justagevorrichtung 3 entnommen und in einen Ofen 6 (Fig. 2) gelegt werden können. Die Justagevorrichtung 3 ist dann bereits nach der kurzen Aushärtezeit des UV-Klebemittels zur Aufnahme eines nächsten Teilepaares 1' und 2' bereit. Die längere Aushärtung des Epoxy-Klebemittels 4 kann gleichzeitig für eine größere Anzahl von vorfixierten Teilen im Ofen 6 bei erhöhter Temperatur erfolgen. Dadurch wird ein wesentlich kürzerer Produktionsdurchlauf erreicht.

### Abwandlungsmöglichkeiten

Die Teile 1 und 2 müssen nicht notwendigerweise unterschiedlich groß sein. Auch wenn untereinander gleich große Teile lediglich gegeneinander verschoben miteinander verklebt werden sollen, lässt sich die Erfindung anwenden.

## Patentansprüche

1. Klebeverfahren zum Verbinden zweier Teile (1, 2) über eine diese miteinander verbindende, länger aushärtende Klebemittelschicht (4), nachdem zuvor eine Justage vorgenommen worden ist,
dadurch gekennzeichnet,
dass nach dem Aufbringen der Klebemittelschicht (4) und nach dem Anbringen einer Justagevorrichtung (3) ein die beiden Teile (1, 2) miteinander verbindendes, kürzer aushärtendes UV-Klebemittel (5) am Rand der Klebemittelschicht (4) derart aufgebracht wird, dass es für eine UV-Bestrahlung zugänglich ist,
dass anschließend das UV-Klebemittel (5) ausgehärtet, die Justagevorrichtung (3) entfernt und schließlich die länger aushärtende Klebemittelschicht (4) ausgehärtet wird.

2. Klebeverfahren nach Anspruch 1, dadurch gekennzeichnet, dass die Klebemittelschicht (4) aus Epoxy-Klebemittel besteht.

3. Klebeverfahren nach Anspruch 1 oder 2,dadurch gekennzeichnet, dass die Aushärtung der länger aushärtende Klebemittelschicht (4) in einem Ofen (6) erfolgt.

4. Klebeverfahren nach Anspruch 3, dadurch gekennzeichnet, dass mehrere Teilepaare (1, 2; 1', 2') gleichzeitig zum Aushärten der länger aushärtenden Klebemittelschicht (4) in den Ofen (6) gebracht werden.
